# EUROPEAN PATENT APPLICATION

(11) **EP 2 072 214 A2**
(43) Date of publication of application: **24.06.2009**
(21) Application number: 08254017.0
(22) Date of filing: 16.12.2008
(51) Int. Cl.: B29C 45/14, H05K 9/00

(54) **Multi-layered molded article with EMI protection**

(30) Priority: 20.12.2007 CN 200710203283
(71) Applicant: FIH (Hong Kong) Limited, Hong Kong (HK)
(72) Inventor: Wu, Kun-Tsan, Shindian City, Taipei Hsien, Taiwan 231 (CN); Tien, Li-Wen, Shindian City, Taipei Hsien, Taiwan 231 (CN)
(74) Representative: Craven, Ian

(57) **Abstract**

A multi-layered molded article (10) is provided. The multi-layered molded article includes a substrate (14) and a soft layer (12) directly formed on the substrate. The soft layer is made of a base material combined with an anti-EMI material.

## Description

### 1. Field of the Invention

The present invention relates to multi-layer molded articles.

### 2. Description of related art

Molded articles, such as molded shells, are widely used in many technological fields. One example is a molded shell used with a portable electronic device (e.g., a mobile phone) for protecting internal electronic components. Another example is a molded shell used with furniture (e.g., a mini sofa) to provide decoration.

The molded shells may include a plastic substrate having some kind of decorative and/or protective (hereinafter "second") layer formed thereon. The molded shell may be made using an insert molding process. The second layer is placed in the mold cavity and then bonds to the molten plastic injected into the mold for forming the substrate.

Various difficulties may be faced when manufacturing this multi-layer molded article.

Therefore, there is room for improvement within the art.

### BRIEF DESCRIPTION OF THE DRAWING

Many aspects of the present anti-EMI multi-layered molded article can be better understood with reference to the following drawing. The drawing is not necessarily drawn to scale, the emphasis instead being placed upon clearly illustrating the principles of the present anti-EMI multi-layered molded article. Moreover, in the drawing like reference numerals designate corresponding parts throughout the view. Wherever possible, the same reference numbers are used throughout the drawing to refer to the same or like elements of an embodiment.

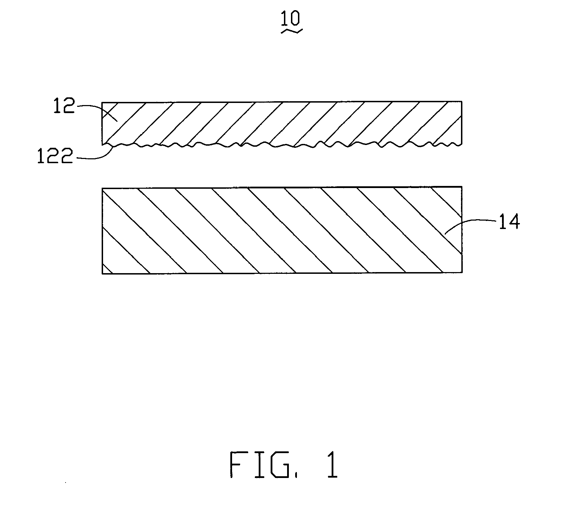

FIG. 1 is a cross-sectional view of an anti-EMI multi-layered molded article according to an exemplary embodiment.

### DETAILED DESCRIPTION OF THE EXEMPLARY EMBODIMENTS

Referring to the drawing, a multi-layered molded article 10 is shown. Article 10 includes a substrate 14 and a soft layer 12 directly formed on the substrate 14.

The substrate 14 can be molded by injection molding. The substrate 14 can be formed by injection molding a moldable material. The moldable material can be any of plastic, rubber, and silicon. The plastic material can be any of polyvinylchloride resin (PVC), polyethylene terephthalate (PET), acrylonitrile-butadiene-styrene (ABS), polycarbonate (PC), polyimide (PI), liquid crystal polymer (LCP), polyetherimide (PEI), polyphenylene sulfide (PPS), polystyrene (PS), polypropylene (PP). In particular, ABS and PCexhibit good adhesion to many softer materials.

When article 10 is a part of an electronic device, the material of the soft layer 12 may be combined with an anti-EMI material to shield the EMI generated by the electronic components of the portable electronic device. The soft layer 12 may be made of a material that is soft relative to the substrate 14. Exemplary soft materials include leather (natural and artificial), all types of fabrics, woven clothes, textiles, and nylon. If the soft layer 12 is made of fabric, the anti-EMI material can be a metal wire/metal fiber (e.g. copper, nickel, stainless steel) or a metallic film (copper, nickel, silver). For example, the fabric may be meshed with metal wire or metal fiber. The metal wire or metal fiber also may be embedded in the fabric. Alternatively, the fabric may be coated a metallic film by plating or electroless plating.

The soft layer 12 has an exterior bonding surface 122 bonding with a corresponding exterior surface (not labeled) of the substrate 14. During the injection molding process, the soft layer 12 is directly bonded with the molten material being injected into the mold for forming the substrate 14. Since the bonding surface 122 is rough having a plurality of tiny pores or projections, these portions of the bonding surface interlock with the molten material, thereby increasing the adhesion of the soft layer 12 to the substrate 14. Soft layers 12 made of cotton fabric are naturally rough. However, soft layers 12 made of artificial leather, are not naturally rough. Therefore, the soft layer 12 may require surface treatment (e.g., grinded) to achieve a rough surface.

When manufacturing the multi-layered molded article 10, the substrate 14 is insert molded with the soft layer 12 using typical insert molding decorating (IMD) technology. During this stage, the material of substrate 14 is softened, such as by heating, allowing it to join with the bonding surface 122 of the soft layer 12.

It is to be understood, however, that even through numerous characteristics and advantages of the present invention have been set forth in the foregoing description, together with details of the structure and function of the invention, the disclosure is illustrative only, and changes may be made in detail, especially in matters of shape, size, and arrangement of parts within the principles of the invention to the full extent indicated by the broad general meaning of the terms in which the appended claims are expressed.

## Claims

1. A multi-layered molded article, comprising:
a substrate; and
a soft layer directly formed on the substrate;
wherein the soft layer is made of a base material combined with an anti-EMI material, the base material selected from the group consisting of: leather and fabric.

2. The multi-layered molded article as claimed in claim 1, wherein the anti-EMI material is either a metal wire, a metal fiber or a metallic film.

3. The multi-layered molded article as claimed in claim 2, wherein the metal wire or the metal fiber is made of a material selected from the group consisting of copper, nickel, and stainless steel, and the metallic film is made from a material selected from the group consisting of copper, nickel, and silver.

4. The multi-layered molded article as claimed in claim 1, wherein the soft layer is made of a material selected from the group consisting of natural leather, artificial leather, fabrics, woven clothes, textiles, and nylon.

5. The multi-layered molded article as claimed in claim 4, wherein the soft layer comprises a bonding surface, the bonding surface bonded to an exterior surface of the substrate.

6. The multi-layered molded article as claimed in claim 5, wherein the bonding surface is rough.

7. The multi-layered molded article as claimed in claim 6, wherein the bonding surface is rough because the soft layer is made of cotton fabric.

8. The multi-layered molded article as claimed in claim 6, wherein the bonding surface is surface treated to be rough.

9. The multi-layered molded article as claimed in claim 6, wherein the bonding surface has a plurality of tiny pores or projections.

10. The multi-layered molded article as claimed in claim 1, wherein the substrate is made of a material selected from the group consisting of one of plastic, rubber, and silicon.

11. The multi-layered molded article as claimed in claim 1, wherein the fabric is meshed or embedded with metal wire or metal fiber

12. The multi-layered molded article as claimed in claim 1, wherein the fabric is coated a metallic film by plating or electroless plating.
